# EUROPEAN PATENT SPECIFICATION

(11) **EP 4 358 213 B1**
(45) Date of publication and mention of the grant of the patent: **18.11.2026**
(21) Application number: 23763671.7
(22) Date of filing: 27.02.2023
(51) Int. Cl.: H01M 10/04, H01M 10/44, G01R 31/364, G01R 31/385, H01M 10/48, H01M 10/42, H01M 50/107, H01M 50/213

(54) **BATTERY CELL PRESSING JIG**
BATTERIEZELLENANDRUCKSPANNVORRICHTUNG
GABARIT DE PRESSAGE D'ÉLÉMENT DE BATTERIE

(30) Priority: 03.03.2022 KR 20220027690
(43) Date of publication of application: 24.04.2024
(73) Proprietor: LG Energy Solution, Ltd., Seoul 07335 (KR)
(72) Inventor: OH, Myung Geun, Daejeon 34122 (KR); LEE, Tae Gyu, Daejeon 34122 (KR); CHOI, Hae Won, Daejeon 34122 (KR)
(74) Representative: Goddar, Heinz J.
(86) International application number: PCT/KR2023/002710
(87) International publication number: WO 2023/167472

(56) References cited:
- WO-A1-2022/025705
- JP-A- 2022 513 663
- KR-A- 19990 067 764
- KR-A- 20120 108 260
- KR-A- 20120 108 260
- KR-A- 20130 030 545
- KR-A- 20140 107 917
- KR-A- 20220 013 849
- US-A1- 2010 047 676
- US-A1- 2012 003 508
- US-A1- 2018 277 802
- US-A1- 2022 045 397
- US-A1- 2023 045 364

## Description

### [Technical Field]

The present invention relates to a battery cell pressing jig for assembling a battery cell for manufacturing a battery module.

This application claims the benefit of priority based on Korean Patent Application No. 10-2022-0027690, filed on March 03, 2022.

### [Background Technology of the Invention]

Recently, chargeable and dischargeable secondary batteries have been widely used as energy sources of wireless mobile devices.

In addition, secondary batteries are attracting attention not only as energy sources of portable devices such as cellphones, laptop computers, and camcorders, but also as energy sources of electric vehicles and hybrid electric vehicles proposed as a solution to air pollution due to gasoline and diesel vehicles using fossil fuels.

Therefore, types of applications using secondary batteries are being variously diversified due to the advantages of the secondary batteries. In the future, secondary batteries are expected to be applied to more fields and products.

Such secondary batteries are classified into lithium ion batteries, lithium ion polymer batteries, lithium polymer batteries, and the like according to a configuration of an electrode and an electrolyte. The use of lithium ion polymer batteries, which are less likely to leak an electrolyte and easy to manufacture, is increasing.

In general, according to a shape of a battery case, secondary batteries are classified into cylindrical type batteries in which an electrode assembly is embedded in a cylindrical metal can, prismatic batteries in which an electrode assembly is embedded in a prismatic metal can, and pouch type battery cells in which an electrode assembly is embedded in a pouch type case of an aluminum laminate sheet.

An electrode assembly embedded in a battery case is a chargeable and dischargeable power generating device which has a structure including a positive electrode, a negative electrode, and a separator interposed between the positive electrode and the negative electrode. Electrode assemblies are classified into jelly-roll type electrode assemblies in which a separator is interposed between a positive electrode and a negative electrode, each of which is provided in the form of a long sheet coated with an active material, and then the positive electrode, the separator, and the negative electrode are wound, and stacked type electrode assemblies in which a plurality of positive and negative electrodes, which are formed in a certain size, are sequentially stacked with separators interposed therebetween.

Meanwhile, such a battery cell is manufactured through an assembly process of assembling the battery cell and an activation process of activating the battery cell, and in an activation operation, a process of charging/discharging the manufactured battery cell at a constant voltage is repeated several times, and finally, the battery cell having a required voltage is shipped.

Here, when a battery module is manufactured, the battery cell is assembled using a pressing jig.

In this case, when the state of the battery cell is checked in a state in which the pressing jig is assembled to the battery cell, after the pressing jig is separated from the battery cell, the presence or absence of an abnormality of the battery cell is checked.

That is, there have been problems that there is a hassle of having to separate a battery cell from a pressing jig whenever a short circuit or the like occurs in the battery cell to then measure a voltage of the battery cell, and manufacturing takes a long time.

In addition, there has been a problem that, even when a battery cell is charged or discharged, since an operation should be performed after a pressing jig is separated from a battery cell, the operation is cumbersome.

### [Related Art Documents]

(Patent Document 1) Korean Patent Registration No. 10-1764497
Prior art relevant to the present invention is given by KR 2012 0108260 A, US 2018/277802 A1, WO 2022/025705 A1, KR20220013849 A, US 2010/047676 A1, US 2022/045397 A1, and JP 2022 513663 A. It is known from the prior art a battery pack comprising a battery laminate in which a plurality of battery cells or unit modules which are connected in direct and/or in series are laminated; a voltage sensing elements electrically connecting the battery pack control part, for detecting voltage of the battery cell or unit module by being electrically connected to an electrode terminal connection part of battery cells respectively located on a front side and/or a backside of the battery laminate; and a safety element shutting off a connection circuit of the voltage sensing member to the battery control part in case of a short circuit in the battery sensing member.

### [Description of the Invention]

### [Technical Problem]

An object of the present invention is to provide a battery cell pressing jig capable of charging and discharging a battery cell as well as measuring a voltage of the battery cell without separation of a pressing jig when a short circuit occurs in the battery cell in a state in which the pressing jig is assembled to the battery cell for manufacturing a battery module.

### [Technical Solution]

The present invention is defined according to the appended independent claim. Particular embodiments are given by the additional features of the appended dependent claims. A battery cell pressing jig for assembling a battery cell includes a lower plate of which an upper surface is provided with a first pressing member for seating and arranging a plurality of battery cells thereon, an upper plate which is provided above the lower plate and of which a lower surface is provided with a second pressing member, on which the plurality of battery cells are seated in an arranged state, thereon, a pressing part configured to press both the upper plate and the lower plate toward the battery cell, and a plurality of sensing members coupled onto the upper plate to be electrically connected to the plurality of battery cells.

The battery cell is a cylindrical battery cell.

A plurality of first seating grooves, with which a lower outer periphery of the battery cell is seated in contact, are formed in upper surface of the first pressing member, and a plurality of second seating grooves, with which an upper outer periphery of the battery cell is seated in contact, are formed in a lower surface of the second pressing member.

The first and second pressing members are made of foam.

A plurality of sensing holes in which the sensing members are inserted and installed may be formed to pass through the upper plate.

The sensing member may be disposed in a vertical upward direction corresponding to a position of an electrode terminal of the battery cell seated on the first pressing member and the second pressing member.

The sensing member may be a pogo pin of which a conductive tip electrically connected to an electrode terminal of the battery cell is movable forward or backward by an embedded elastic member.

The sensing member may be a measurement pin including a tip made of a conductive material to be electrically connected to an electrode terminal of the battery cell.

The battery cell pressing jig may further include a measurement device configured to measure a current or voltage of the battery cell electrically connected to the sensing member.

The battery cell pressing jig may further include a charge/discharge device configured to charge/discharge the battery cell electrically connected through the sensing member.

### [Advantageous Effects]

According to the present invention, when a short circuit occurs in a battery cell in a state in which a pressing jig is assembled to the battery cell for manufacturing a battery module, without separation of the pressing jig, a voltage of the battery cell can be measured, and the battery cell can also be charged or discharged. Thus, a module manufacturing time can be reduced, and the productivity of the battery module can be improved.

### [Brief Description of the Drawings]

FIG. 1 is a schematic perspective view illustrating a battery cell pressing jig according to the present invention.
FIG. 2 is a schematic plan view illustrating the battery cell pressing jig according to the present invention.
FIG. 3 is a schematic side cross-sectional view illustrating the battery cell pressing jig according to the present invention.
FIG. 4 is a schematic view illustrating a state in which a sensing member is installed on the battery cell pressing jig according to one embodiment of the present invention.
FIG. 5 is a schematic view illustrating the sensing member according to one embodiment of the present invention.
FIG. 6 is a schematic view illustrating a state in which a sensing member is installed on a battery cell pressing jig according to another embodiment of the present invention.
FIG. 7 is a schematic view illustrating the sensing member according to another embodiment of the present invention.

### [Best Mode for Carrying Out the Invention]

Hereinafter, the present invention will be described in detail. Prior to the description, it should be understood that terms used in the present specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

It should be understood that terms such as "include" or "have" used throughout the specification of the present invention are intended to indicate the presence of a feature, number, step, operation, component, part, or a combination thereof described in the specification, and they do not preclude the possibility of the presence or addition of one or more other features or numbers, steps, operations, components, parts or combinations thereof.

Also, when a portion such as a layer, a film, an area, a plate, etc. is referred to as being "on" another portion, this includes not only the case where the portion is "directly on" another portion but also the case where still another portion is interposed therebetween. On the other hand, when a portion such as a layer, a film, an area, a plate, etc. is referred to as being "under" another portion, this includes not only the case where the portion is "directly under" another portion but also the case where still another portion is interposed therebetween. In addition, to be disposed "on" in the present application may include the case disposed at the bottom as well as the top.

### (First embodiment)

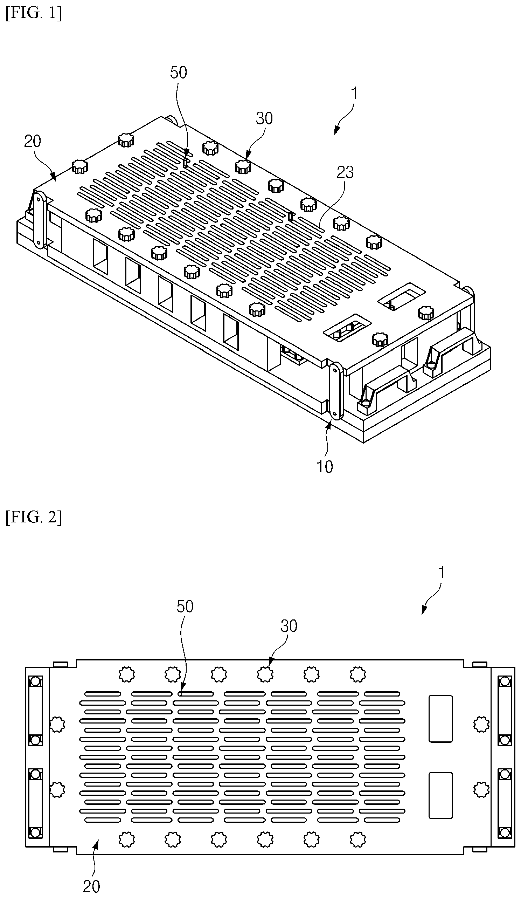

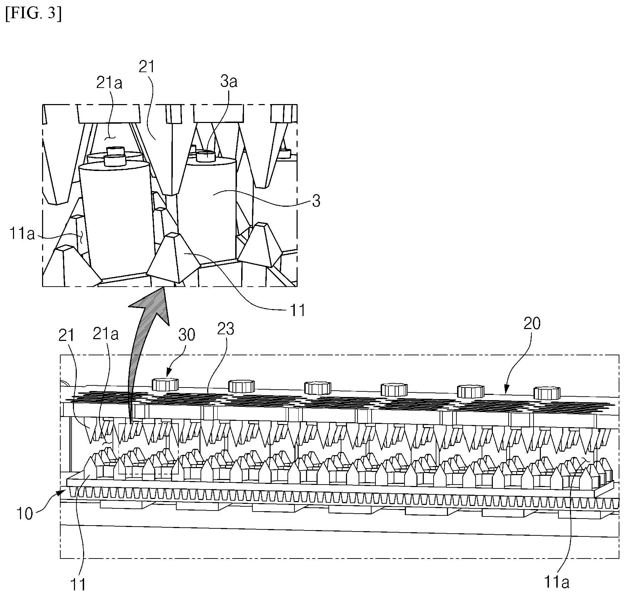

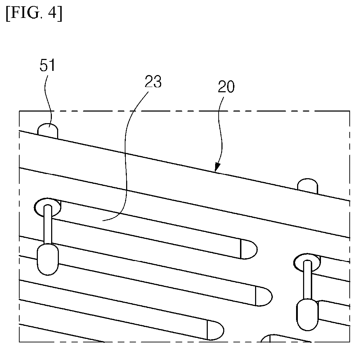

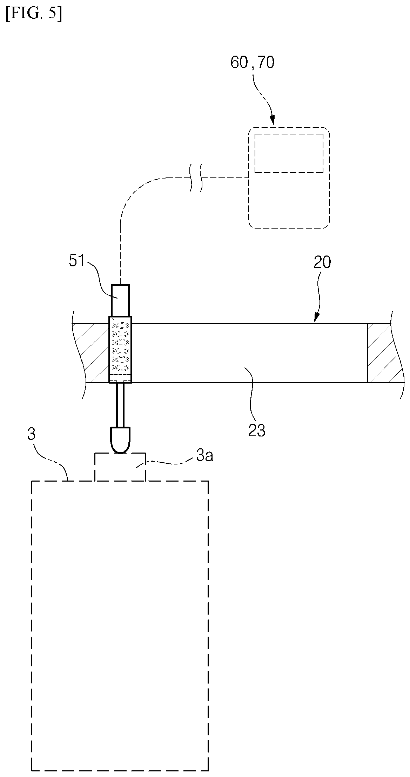

FIG. 1 is a schematic perspective view illustrating a battery cell pressing jig according to the present invention. FIG. 2 is a schematic plan view illustrating the battery cell pressing jig according to the present invention. FIG. 3 is a schematic side cross-sectional view illustrating the battery cell pressing jig according to the present invention. FIG. 4 is a schematic view illustrating a state in which a sensing member is installed on the battery cell pressing jig according to one embodiment of the present invention. FIG. 5 is a schematic view illustrating the sensing member according to one embodiment of the present invention.

A battery cell pressing jig 1 according to the present invention is for installing a plurality of battery cells 3 to manufacture a battery module and includes a lower plate 10, an upper plate 20, a pressing part 30, and sensing members 50.

A first pressing member 11 is provided on an upper surface of the lower plate 10 for the plurality of battery cells 3 to be seated and arranged.

A plurality of first seating grooves 11a are formed on an upper surface of the first pressing member 11 for a lower outer periphery of the battery cell 3 to be seated in contact therewith. An edge of the first seating groove 11a is formed to protrude upward in a shape surrounding the lower outer periphery of the battery cell 3.

The upper plate 20 is provided above the lower plate 10, and a plurality of second seating grooves 21a, with which an upper outer periphery of the battery cell 3 seated on the first pressing member 11 of the lower plate 10 is seated in contact, are formed therein.

Even in this case, an edge of the second seating groove 21a is formed to protrude downward in a shape surrounding the upper outer periphery of the battery cell 3.

In this way, in the first pressing member 11 and the second pressing member 21, the plurality of first seating grooves 11a and the plurality of second seating grooves 21a are formed in a concavely recessed shape, and the edges of the first seating groove 11a and the second seating groove 21a are formed to protrude in a pointed shape so that the battery cells 3 are easily seated and the seated battery cells 3 do not interfere with each other.

Here, the battery cell 3 is provided as a cylindrical battery cell. Here, each of the seating grooves 11a and 21a is formed in a shape corresponding to the cylindrical battery cell for the battery cell 3 to be installed in each of the plurality of seating grooves 11a and 21a formed in the first pressing member 11 and the second pressing member 21.

Meanwhile, the first pressing member 11 and the second pressing member 21 may be made of foam having certain compressibility.

The pressing part 30 presses both the upper plate 20 and the lower plate 10 toward the battery cell 3 to fix the upper plate 20 and the lower plate 10.

Here, the pressing part 30 may be provided as a fastening member including a bolt.

A plurality of fastening holes (not shown) are formed to pass through an edge of the upper plate 20 to be spaced a certain interval apart from each other, and fastening grooves (not shown) corresponding to the fastening holes are formed at an edge of the lower plate 10.

Due to such a structure, after the fastening hole of the upper plate 20 and the fastening groove of the lower plate 10 are positioned to correspond to each other, the fastening member may be coupled to the fastening hole and the fastening groove to press the battery cell 3 installed in the upper plate 20 and the lower plate 10.

In this case, the pressing part 30 may be fastened to press the upper plate 20 against the lower plate 10, and thus the first pressing member 11 and the second pressing member 21 may come into contact with upper and lower surfaces of the battery cells 3 to press the plurality of battery cells 3, thereby resizing lengths of the battery cells 3.

The sensing members 50 are coupled onto the upper plate 20 to be electrically connected to the plurality of battery cells 3.

To this end, the sensing member 50 is in contact with and electrically connected to an electrode terminal 3a of the battery cell 3 to form an externally accessible electrical path. For example, a voltage of the battery cell 3 may be measured through the sensing member 50 without disassembling the battery cell pressing jig 1.

In addition, by using the sensing member 50, the battery cell 3 may be charged or discharged while fixed to the battery cell pressing jig 1.

In addition, the sensing member 50 may come in contact with a bus bar connecting the plurality of battery cells 3 to each other to measure voltages of the plurality of battery cells 3 and simultaneously charge/discharge the plurality of battery cells 3.

Meanwhile, a plurality of sensing holes 23 through which the sensing members 50 are inserted and installed are formed to pass through the upper plate 20.

In this way, the plurality of sensing holes 23 may be formed in the upper plate 20, and the sensing member 50 may be inserted into and installed in the sensing hole 23 formed at a position corresponding to the electrode terminal 3a of each battery cell 3, so that a voltage of the battery cell 3 can be easily measured.

Here, the sensing hole 23 may be formed in a long slot shape in a length direction of the upper plate 20 and may be formed such that the sensing member 50 is forcibly fitted and inserted therein and separated therefrom.

As described above, the plurality of sensing holes 23 are formed in the upper plate 20, and thus the sensing member 50 is disposed in a vertical upward direction corresponding to a position of the electrode terminal 3a of the battery cell 3 seated on the first pressing member 11 and the second pressing member 21.

Although the sensing hole 23 is formed in a long slot shape in one embodiment of the present invention, the sensing hole 23 may be formed in a circular shape, and a shape of the sensing hole 23 is not limited thereto.

In addition, although the sensing member 50 is detachably inserted into and installed in the sensing hole 23 in one embodiment of the present invention, the sensing member 50 may be fixed to the sensing hole 23 and provided integrally. In this case, the sensing member 50 is fixedly provided at a position corresponding to the electrode terminal 3a of the battery cell 3.

Meanwhile, the sensing member 50 is provided as a pogo pin 51 of which a conductive tip electrically connected to the electrode terminal 3a of the battery cell 3 is movable forward or backward by an embedded elastic member.

Specifically, the pogo pin 51 has a cylindrical shape, an elastic member such as a spring is installed therein, and the tip for probing the electrode terminal 3a of the battery cell 3 is made of a conductive metal material and is inserted into the sensing hole 23 of the upper plate 20 and then moved forward toward the battery cell 3 to come into elastic contact with the electrode terminal 3a, thereby making electrical connection.

As described above, since the pogo pin 51 is elastically connected to the electrode terminal 3a, electrical characteristics such as a voltage or current of the battery cell 3 can be accurately tested.

Here, the battery cell pressing jig 1 according to one embodiment of the present invention may further include a measurement device 60 electrically connected to the sensing member 50 to measure a current or voltage of the battery cell 3.

In addition, the battery cell pressing jig 1 may further include a charge/discharge device 70 that directly charges or discharges the battery cell 3 electrically connected to the sensing member 50 without removal of the battery cell pressing jig 1.

In this case, one side of the sensing member 50 exposed to the outside of the upper plate 20 may be connected to the measurement device 60 and the charge/discharge device 70 through electrical wiring to apply a current to the battery cell 3, measure a voltage of the battery cell 3, or charge/discharge the battery cell 3.

### (Second embodiment)

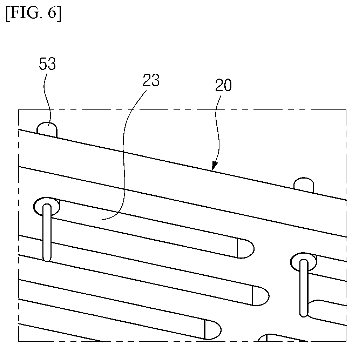

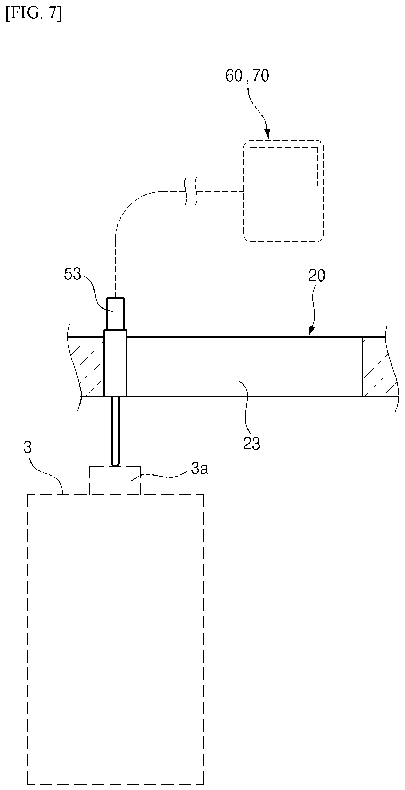

FIG. 6 is a schematic view illustrating a state in which a sensing member is installed on a battery cell pressing jig according to another embodiment of the present invention. FIG. 7 is a schematic view illustrating the sensing member according to another embodiment of the present invention.

As illustrated in FIGS. 6 and 7, a sensing member 50 according to a second embodiment is provided as a measurement pin 53 of which a conductive tip electrically connected to an electrode terminal 3a of a battery cell 3 is provided at a lower portion thereof.

Specifically, the measurement pin 53 has a rod-shaped body, a tip made of a conductive metal material to probe the electrode terminal 3a of the battery cell 3 is formed at a lower portion thereof, and a cover body made of a synthetic resin material is formed at an outer periphery thereof.

As described above, the measurement pin 53 is installed in a sensing hole 23 of an upper plate 20 and then pressed toward the battery cell 3 to bring the tip formed at the lower portion of the measurement pin 53 into contact with the electrode terminal 3a of the battery cell 3 so that the tip is electrically connected to the battery cell 3.

### [Description of reference numerals]

| | | | |
|---|---|---|---|
| 1: | battery cell press jig | 3: | battery cell |
| 3a: | electrode terminal | 10: | lower plate |
| 11: | first pressing member | 11a: | first seating groove |
| 20: | upper plate | 21: | second pressing member |
| 21a: | second seating groove | 30: | pressing part |
| 50: | sensing member | 51: | pogo pin |
| 53: | measurement pin | 60: | measurement device |
| 70: | charge/discharge device | | |

### Industrial Applicability

The present invention is useful for use in manufacturing secondary batteries including cylindrical battery cells.

## Claims

1. A battery cell pressing jig (1) for assembling a battery cell (3), the battery cell pressing jig (1) comprising:
a lower plate (10) having an upper surface provided with a first pressing member (11) for seating and arranging a plurality of battery cells thereon;
an upper plate (20) disposed above the lower plate (10) and having a lower surface provided with a second pressing member (21) configured so that the plurality of battery cells are to be seated thereon in their arranged state;
a pressing part (30) configured to press the upper plate (20) and the lower plate (10) toward the plurality of battery cells; and
a plurality of sensing members (50) coupled onto the upper plate (20) to be electrically connected to the plurality of battery cells,
wherein the plurality of battery cells are cylindrical battery cells,
wherein a plurality of first seating grooves (11a), in which a lower outer periphery of each of the plurality of battery cells are seated, are formed in an upper surface of the first pressing member (11), and
wherein a plurality of second seating grooves (21a), in which an upper outer periphery of each of the plurality of battery cells are seated, are formed in a lower surface of the second pressing member (21),
wherein the first pressing member (11) and the second pressing member (21) are made of foam,
wherein, in the first pressing member (11) and the second pressing member (21), the plurality of first seating grooves (11a) and the plurality of second seating grooves (21a) are formed in a concavely recessed shape, and the edges of the first seating groove (11a) and the second seating groove (21a) are formed to protrude in a pointed shape.

2. The battery cell pressing jig (1) according to claim 1, wherein a plurality of sensing holes in which the plurality of sensing members (50) are inserted and installed pass through the upper plate (20).

3. The battery cell pressing jig (1) according to claim 1, wherein each of the plurality of sensing members (50) is disposed in a vertical direction corresponding to a position of an electrode terminal (3a) of a corresponding one of the plurality of battery cells seated on the first pressing member (11) and the second pressing member (21).

4. The battery cell pressing jig (1) of claim 1, wherein each of the plurality of sensing members (50) is a pogo pin (51) having a conductive tip electrically connected to an electrode terminal (3a) of a corresponding one of the plurality of battery cells and is movable upwardly and downwardly by an embedded elastic member.

5. The battery cell pressing jig (1) of claim 1, wherein each of the plurality of sensing members (50) is a measurement pin (53) including a tip made of a conductive material to be electrically connected to an electrode terminal (3a) of a corresponding one of the plurality of battery cells.

6. The battery cell pressing jig (1) of claim 1, further comprising a measurement device (60) configured to measure a current or voltage of a battery cell (3) of the plurality of battery cells electrically connected to a sensing member of the plurality of sensing members (50).

7. The battery cell pressing jig (1) of claim 1, further comprising a charge/discharge device (70) configured to charge or discharge a battery cell (3) of the plurality of battery cells electrically connected through a sensing member of the plurality of sensing members (50).

8. The battery cell pressing jig (1) of claim 1, wherein the first pressing member (11) and the second pressing member (21) each have a plurality of seating grooves (11a, 21a), whose edges are formed to protrude in a shape surrounding the lower outer periphery and the upper outer periphery of the battery cell, respectively.

9. The battery cell pressing jig (1) of claim 8, wherein the edges of the seating grooves (11a, 21a) are formed to protrude in a pointed shape comprising four flat side surfaces.

## Patentansprüche

1. Batteriezellen-Pressvorrichtung (1) zur Bildung einer Batteriezelle (3), wobei die Batteriezellen-Pressvorrichtung (1) aufweist:
eine untere Platte (10), die eine obere Oberfläche aufweist, die mit einem ersten Presselement (11) zur Aufnahme und Anordnung von mehreren Batteriezellen darauf bereitgestellt ist;
eine obere Platte (20), die über der unteren Platte (10) angeordnet ist und eine untere Oberfläche aufweist, die mit einem zweiten Presselement (21) bereitgestellt ist, das so konfiguriert ist, dass die mehreren Batteriezellen in ihrem angeordneten Zustand darauf aufzunehmen sind;
ein Pressteil (30), das so konfiguriert ist, dass es die obere Platte (20) und die untere Platte (10) in Richtung der mehreren Batteriezellen presst; und
mehrere Erfassungselemente (50), die an die obere Platte (20) gekoppelt sind, um elektrisch mit den mehreren Batteriezellen verbunden zu werden,
wobei die mehreren Batteriezellen zylindrische Batteriezellen sind,
wobei mehrere erste Aufnahmenuten (11a), in denen ein unterer Außenumfang jeder der mehreren Batteriezellen aufgenommen ist, in einer oberen Oberfläche des ersten Presselements (11) ausgebildet sind, und
wobei mehrere zweite Aufnahmenuten (21a), in denen ein oberer Außenumfang jeder der mehreren Batteriezellen aufgenommen ist, in einer unteren Oberfläche des zweiten Presselements (21) ausgebildet sind,
wobei das erste Presselement (11) und das zweite Presselement (21) aus Schaumstoff hergestellt sind,
wobei in dem ersten Presselement (11) und dem zweiten Presselement (21) die mehreren ersten Aufnahmenuten (11a) und die mehreren zweiten Aufnahmenuten (21a) in einer konkav vertieften Form ausgebildet sind und die Ränder der ersten Aufnahmenut (11a) und der zweiten Aufnahmenut (21a) so ausgebildet sind, dass sie in einer spitzen Form vorstehen.

2. Batteriezellen-Pressvorrichtung (1) nach Anspruch 1, wobei mehrere Erfassungslöcher, in die die mehreren Erfassungselemente (50) eingesetzt und installiert sind, durch die obere Platte (20) verlaufen.

3. Batteriezellen-Pressvorrichtung (1) nach Anspruch 1, wobei jedes der mehreren Erfassungselemente (50) in einer vertikalen Richtung angeordnet ist, die einer Position eines Elektrodenanschlusses (3a) einer jeweiligen Batteriezelle der mehreren Batteriezellen entspricht, die auf dem ersten Presselement (11) und dem zweiten Presselement (21) aufgenommen sind.

4. Batteriezellen-Pressvorrichtung (1) nach Anspruch 1, wobei jedes der mehreren Erfassungselemente (50) ein Pogo-Stift (51) ist, der eine leitfähige Spitze aufweist, die elektrisch mit einem Elektrodenanschluss (3a) einer jeweiligen Batteriezelle der mehreren Batteriezellen verbunden ist und durch ein eingebettetes elastisches Element nach oben und unten bewegbar ist.

5. Batteriezellen-Pressvorrichtung (1) nach Anspruch 1, wobei jedes der mehreren Erfassungselemente (50) ein Messstift (53) ist, der eine Spitze aufweist, die aus einem leitfähigen Material hergestellt ist, um elektrisch mit einem Elektrodenanschluss (3a) einer jeweiligen Batteriezelle der mehreren Batteriezellen verbunden zu werden.

6. Batteriezellen-Pressvorrichtung (1) nach Anspruch 1, die ferner eine Messvorrichtung (60) aufweist, die so konfiguriert ist, dass sie einen Strom oder eine Spannung einer Batteriezelle (3) der mehreren Batteriezellen misst, die elektrisch mit einem Erfassungselement der mehreren Erfassungselemente (50) verbunden ist.

7. Batteriezellen-Pressvorrichtung (1) nach Anspruch 1, die ferner eine Lade-/Entladevorrichtung (70) aufweist, die so konfiguriert ist, dass sie eine Batteriezelle (3) der mehreren Batteriezellen lädt oder entlädt, die elektrisch durch ein Erfassungselement der mehreren Erfassungselemente (50) verbunden ist.

8. Batteriezellen-Pressvorrichtung (1) nach Anspruch 1, wobei das erste Presselement (11) und das zweite Presselement (21) jeweils mehrere Aufnahmenuten (11a, 21a) aufweisen, deren Ränder so ausgebildet sind, dass sie in einer Form vorstehen, die den unteren Außenumfang bzw. den oberen Außenumfang der Batteriezelle umgibt.

9. Batteriezellen-Pressvorrichtung (1) nach Anspruch 8, wobei die Ränder der Aufnahmenuten (11a, 21a) so ausgebildet sind, dass sie in einer spitzen Form vorstehen, die vier flache Seitenflächen aufweist.

## Revendications

1. Gabarit de pressage d'élément de batterie (1) pour assembler un élément de batterie (3), le gabarit de pressage d'élément de batterie (1) comprenant :
une plaque inférieure (10) possédant une surface supérieure équipée d'un premier élément de pressage (11) pour placer et agencer dessus une pluralité d'éléments de batterie ;
une plaque supérieure (20) disposée au-dessus de la plaque inférieure (10), et possédant une surface inférieure équipée d'un deuxième élément de pressage (21) configuré de sorte que la majorité d'éléments de batterie y soient placés dans leur état agencé ;
une dispositif de pressage (30) configuré pour presser la plaque supérieure (20) et la plaque inférieure (10) vers la pluralité d'éléments de la batterie ; et
une pluralité d'organes détecteurs (50) couplés sur la plaque supérieure (20) pour être connectés électriquement à la pluralité d'éléments de batterie,
la pluralité d'éléments de batterie étant des éléments de batterie cylindriques,
une pluralité de premières rainures d'assise (11a), dans lesquelles un pourtour extérieur inférieur de chacun de la pluralité d'éléments de batterie est placé, étant formées sur une surface supérieure du premier élément de pressage (11), et
une pluralité de deuxièmes rainures d'assise (21a), dans lesquelles un pourtour extérieur supérieur de chacun de la pluralité d'éléments de batterie est placé, étant formées sur une surface inférieure du deuxième élément de pressage (21), et
le premier élément de pressage (11) et le deuxième élément de pressage (21) étant réalisés en mousse,
et dans le premier élément de pressage (11) et le deuxième élément de pressage (21), la pluralité de premières rainures d'assise (11a) et la pluralité de deuxièmes rainures d'assise (21a) étant réalisées sous une forme évidée concave, et les bords de la première rainure d'assise (11a) et de la deuxième rainure d'assise (21a) étant réalisés de façon à être saillants avec une forme pointue.

2. Gabarit de pressage d'élément de batterie (1) selon la revendication 1, une pluralité de trous de détection dans lesquels la pluralité d'organes détecteurs (50) sont insérés et installés au-delà de la plaque supérieure (20) qu'ils traversent.

3. Gabarit de pressage d'élément de batterie (1) selon la revendication 1, chacun des organes détecteurs (50) étant disposé dans une direction verticale en correspondance avec une position d'une borne d'électrode (3a) d'un élément correspondant parmi la pluralité d'éléments de batterie placés sur le premier élément de pressage (11) et le deuxième élément de pressage (21).

4. Gabarit de pressage d'éléments de batterie (1) selon la revendication 1, chacun de la pluralité d'organes détecteurs (50) étant est une broche POGO (51) dont l'embout conducteur est connecté électriquement à une borne d'électrode (3a) d'un élément correspondant parmi la pluralité d'éléments de batterie, et peut être déplacé en haut et en bas par un élément élastique intégré.

5. Gabarit de pressage d'éléments de batterie (1) selon la revendication 1, chacun de la pluralité d'organes détecteurs (50) étant une broche de mesure (53) possédant un embout réalisé avec une matière conductrice afin d'être connecté électriquement à une borne d'électrode (3a) d'un élément correspondant de la pluralité d'éléments de batterie.

6. Gabarit de pressage d'éléments de batterie (1) selon la revendication 1, comprenant en outre un dispositif de mesure (60) configuré pour mesurer l'intensité ou la tension d'un élément de batterie (3) de la pluralité d'éléments de batterie connectés électriquement à un organe détecteur parmi la pluralité d'organes détecteurs (50).

7. Gabarit de pressage d'éléments de batterie (1) selon la revendication 1, comprenant en outre un dispositif de charge/décharge (70) configuré pour charger ou décharger un élément de batterie (3) de la pluralité d'éléments de batterie connectés électriquement par le biais d'un organe détecteur parmi la pluralité d'organes détecteurs (50).

8. Gabarit de pressage d'éléments de batterie (1) selon la revendication 1, le premier élément de pressage (11) et le deuxième élément de pressage (21) possédant chacun une pluralité de rainures d'assise (11a, 21a), dont les bords sont formés de façon à être saillants sous une forme entourant le pourtour extérieur inférieur et le pourtour extérieur supérieur de l'élément de batterie respectivement.

9. Gabarit de pressage d'éléments de batterie (1) selon la revendication 8, les bords des rainures d'assise (11a, 21a) étant formés de façon à être saillants sous une forme pointue comprenant quatre surfaces latérales plates.
